# EUROPÄISCHE PATENTSCHRIFT

(11) **EP 2 789 216 B1**
(45) Veröffentlichungstag und Bekanntmachung des Hinweises auf die Patenterteilung: **18.07.2018**
(21) Anmeldenummer: 12784485.0
(22) Anmeldetag: 11.10.2012
(51) Int. Cl.: H05K 5/00, F16H 61/00

(54) **GETRIEBESTEUERMODUL**
GEARBOX CONTROL MODULE
MODULE DE COMMANDE DE BOÎTE DE VITESSES

(30) Priorität: 08.12.2011 DE 102011088031
(43) Veröffentlichungstag der Anmeldung: 15.10.2014
(73) Patentinhaber: Robert Bosch GmbH, 70442 Stuttgart (DE)
(72) Erfinder: ZWEIGLE, Peter, 71254 Ditzingen (DE); BRAUN, Holger, 70435 Stuttgart (DE); KIRCHER, Michael, 71691 Freiberg (DE)
(86) Internationale Anmeldenummer: PCT/EP2012/070174
(87) Internationale Veröffentlichungsnummer: WO 2013/083318

(56) Entgegenhaltungen:
- EP-A1- 1 705 068
- EP-A2- 1 193 423
- WO-A2-2010/108532
- DE-A1- 19 710 931
- DE-A1-102006 001 890
- DE-A1-102006 054 279
- JP-A- 1 312 252
- US-A1- 2010 229 677

## Beschreibung

### GEBIET DER ERFINDUNG

Die Erfindung betrifft ein Getriebe mit einem Hydrauliksteuermodul und einem Getriebesteuermodul für ein Fahrzeug. Ein derartiges Getriebe ist aus der DE-A-19710931 bekannt.

### HINTERGRUND DER ERFINDUNG

Zur Steuerung von Automatikgetrieben werden elektronische Steuerungen verwendet, die entweder im Inneren des Getriebegehäuses angeordnet sind (integriertes Steuergerät) oder von außen an das Getriebegehäuse montiert werden (Anbausteuergerät).

Anbausteuergeräte können gegenüber integrierten Steuergeräten den Vorteil aufweisen, dass sie geringeren Temperaturen ausgesetzt sind, und so kostengünstiger ausgestaltet werden können. Allerdings kann der Nachteil entstehen, dass Anbausteuergeräte im Motorraum viel Bauraum benötigen und der Aufwand höher ist, elektrische Leitungen von außen zu den im Inneren des Getriebes liegenden Sensoren und Aktuatoren zu führen.

Integrierte Steuergeräte sind in der Regel als sogenannte elektronische Steuermodule aufgebaut und können eine elektronische Schaltung bzw. einen Elektronikbaustein ("transmission control unit", TCU), Sensoren, mindestens eine Steckverbindung zum Anschluss an den Fahrzeugkabelbaum und elektrische Schnittstellen zum Ansteuern von Aktuatoren enthalten.

### ZUSAMMENFASSUNG DER ERFINDUNG

Es ist Aufgabe der Erfindung ein Getriebe mit einem Hydrauliksteuermodul und einem einfach aufgebauten, leicht zu kühlenden Getriebesteuermodul bereitzustellen.

Diese Aufgabe wird durch den Gegenstand des Anspruchs 1 gelöst. Weitere Ausführungsformen der Erfindung ergeben sich aus den abhängigen Ansprüchen und aus der folgenden Beschreibung.
Ein Aspekt der Erfindung betrifft ein Getriebesteuermodul für ein Getriebe.
Gemäß einer Ausführungsform der Erfindung umfasst das Getriebesteuermodul einen Elektronikbaustein mit einer elektronischen Schaltung zur Steuerung des Getriebes, elektrische Verbindungen beispielsweise zum Verbinden des Elektronikbausteins mit einem Kabelbaum (beispielsweise im Motorraum) und /oder zum Verbinden des Elektronikbausteins mit dem Getriebe (etwa über Leitungen in den Innenraum des Getriebes) und einen Modulträger, auf dem der Elektronikbaustein und die elektrischen Verbindungen angebracht sind.
Der Modulträger ist als Abdeckung zum dichtenden Verschließen eines Getriebeinnenraums ausgeführt.
Mit anderen Worten kann der Modulträger gleichzeitig die Funktion eines Deckels bzw. einer Ölwanne für das Getriebe übernehmen. Damit kann ein Bauteil (Deckel bzw. Ölwanne) entfallen und es ist gewährleistet, dass sich eine Außenseite des Getriebesteuermoduls im kühleren Motorraum befindet. Da das Getriebesteuermodul auch die Funktion eines Deckels übernehmen kann und ein Teil seiner Komponenten im Innenraum des Getriebes angeordnet sind, kann das Getriebesteuermodul einen geringen Bauraumbedarfs im Motorinnenraum aufweisen. Mit dem Getriebesteuermodul kann der Montageaufwand und die Anzahl der benötigten Einzelteile reduziert werden.
Dabei kann der geringe Verdrahtungsaufwand eines in das Getriebe integrierten Steuergeräts erhalten bleiben: Es müssen in der Regel nur die elektrischen Leitungen vom Elektronikbaustein (TCU) zum Fahrzeugkabelbaum aus dem Getriebeinnenraum abgedichtet in den Motorraum geführt werden. Dies kann beispielsweise über einen Getriebestecker erreicht werden.

Der Modulträger hat die Funktion alle Bauteile des Getriebesteuermoduls mechanisch zu halten und zu unterstützen. Der Modulträger kann aus Kunststoff oder aus einem metallischen Träger (zum Beispiel Aluminium) hergestellt sein. Mit der Abdeckung des Getriebes durch den Modulträger kann ein getriebeöldichte Trennung vom Getriebeinnenraum zum Motorraum entsteht. Der Modulträger kann öldicht ausgeführt sein und weist beispielsweise keine Bohrungen oder andere Aussparrungen auf, die nicht verschlossen sind. Gemäß der Erfindung umfasst der Modulträger eine Modulträgerplatte. Die Abdeckung kann also einen im Wesentlichen flächigen Deckel bilden, der über einen Flansch des Getriebegehäuses am Getriebe angebracht wird. Der Modulträger bzw. die Modulträgerplatte weist also einem dem Getriebeinnenraum zugewandte Innenfläche und eine dem Motorraum zugewandte Außenfläche auf. An der Innenfläche ist ein Teil der Komponenten der des Getriebesteuermoduls angebracht, die im Innenraum des Getriebes angeordnet werden. Über die Außenfläche gibt das Getriebesteuermodul Wärme in den Motorraum ab. Gemäß einer Ausführungsform der Erfindung umfasst das Getriebesteuermodul einen Getriebestecker zum Anschließen eines Kabelbaums an das Getriebesteuermodul. Der Getriebestecker ist beispielsweise durch eine Öffnung bzw. Aussparung im Modulträger in den Modulträger integriert. Damit kann der Getriebestecker ohne mechanischen Toleranzausgleich bereits bei der Herstellung des Getriebesteuermoduls angebracht werden.
Mit dem integrierten Getriebestecker kann auch der mechanische Aufwand für die Verbindung zum Fahrzeugkabelbaum reduziert werden. Ein für konventionelle Steuergeräte benötigter Toleranzausgleich, um den Stecker bei der Montage des Getriebesteuermoduls in das Getriebegehäuse zu montieren kann entfallen, da der Stecker direkt im Modulträger integriert werden kann. Der Getriebestecker hat normalerweise die Funktion, eine Schnittstelle von dem Elektronikbaustein (TCU) im Getriebeinnenraum zum Fahrzeugkabelbaum im Motorraum herzustellen.

Der Stecker kann als separates Teil in die Modulträgerplatte montiert werden. Bei einer Kunststoffausführung des Modulträgers kann der Stecker auch direkt in den Modulträger eingespritzt werden.
Gemäß einer Ausführungsform der Erfindung ist der Getriebestecker als separates Teil dichtend in eine Aussparung in den Modulträger montiert.
Gemäß einer Ausführungsform der Erfindung ist der Getriebestecker in den Modulträger eingespritzt. Gemäß der Erfindung ist der Elektronikbaustein auf einer Innenseite des Modulträgers angeordnet und der Elektronikbaustein thermisch mit dem Modulträger verbunden. Das Getriebesteuermodul kann zur Kühlung der Elektronik des Elektronikbausteins die geringe Umgebungstemperatur des Motorraumes nutzen. Der Elektronikbaustein (TCU) ist thermisch mit dem Modulträger derart verbunden, dass eine Verlustleistung nach außen in den kühleren Motorraum abgeleitet werden kann.

Die Kühlfläche des Getriebesteuermoduls (beispielsweise die Außenseite des Modulträgers) kann außerhalb des Getriebes liegen. Über den Modulträger wird die Wärme an die kühlere Motorraumumgebung abgegeben. Dies kann einen wesentlich geringeren Aufwand zur Kühlung der Elektronik bedeuten.

Der Elektronikbaustein (TCU) und deren elektrische Anschlüsse sind im Innenraum des Getriebes angeordnet. So können alle Komponenten mit Schnittstellen innerhalb des Getriebes mit geringem Verdrahtungsaufwand angebunden werden. Neben dem Elektronikbaustein (TCU) und dem Getriebestecker können in das Getriebesteuermodul elektrische Verbindungen, Sensoren, und einen Zwischenstecker integriert sein: Diese Elemente können auf die Innenseite des Modulträgers montiert werden. Die elektrische Verbindungstechnik bzw. die elektrischen Verbindungen können auch zum Verbinden der Komponenten des Getriebesteuermoduls untereinander dienen. Der Zwischenstecker kann zum Anschließen einer elektrischen Leitung aus dem Innenraum des Getriebes verwendet werden.

Gemäß einer Ausführungsform der Erfindung ist der Modulträger als Leiterplatte oder als als umspritztes Stanzgitter ausgeführt. Auf diese Weise können die Funktionen der Bauteile elektrische Verbindungstechnik (d.h. die elektrischen Verbindungen) und Modulträger in einem Bauteil integriert werden. Dieses Bauteil erfüllt die Funktion der Abdeckung des Getriebes. Beispielsweise wird bei dieser Ausführungsform der Getriebestecker ebenfalls in dieses Bauteil integriert. Gemäß einer Ausführungsform der Erfindung ist ein Motorsteuerbaustein für einen elektrischen Motor des Getriebes an einer Außenseite des Modulträgers angebracht. Wird für das Getriebe ein elektrischer Motor benötigt, kann es sinnvoll sein, die elektronischen Komponenten für dessen Ansteuerung auf der Außenseite des Getriebesteuermoduls anzubringen. Dies kann neben den niedrigeren Temperaturen den Vorteil aufweisen, dass diese Komponenten nicht vor Getriebeöl geschützt werden müssen. Da diese Komponenten normalerweise in Reihe in der elektrischen Leitung geschaltet werden, muss sich die Anzahl der Leitungen, welche öldicht in den Getriebeinnenraum geführt werden, nicht ändern. Die Erfindung betrifft ein Getriebe für ein Fahrzeug, beispielsweise ein Automatikgetriebe.

Gemäß der Erfindung umfasst das Getriebe ein Gehäuse mit einer Öffnung (beispielsweise zum Durchführen von elektrischen Leitungen in einen Innenraum des Getriebes) und ein Getriebesteuermodul, so wie es obenstehend und untenstehend beschrieben ist, das die Öffnung dichtend verschließt.
Das Getriebesteuermodul kann unabhängig von der Getriebeendmontage durch einen Zulieferer hergestellt werden. Der Getriebehersteller kann das Getriebesteuermodul auf einfache Weise in sein Getriebe einbauen. Da durch das Einbauen des Getriebesteuermoduls auch die Öffnung verschlossen wird, vereinfacht sich die Montage. Gemäß der Erfindung umfasst das Getriebe weiter ein Hydrauliksteuermodul. Das Getriebe kann hydraulische Komponenten umfassen, die vom Hydraulikmodul angesteuert werden, das wiederum vom Getriebesteuermodul angesteuert werden kann. Die Öffnung im Getriebegehäuse ist von einem Flansch begrenzt, mit dem das Getriebesteuermodul verbunden ist. Das Hydrauliksteuermodul ist zwischen dem Getriebesteuermodul und der Öffnung an dem Flansch angebracht. Auf diese Weise ist das Hydrauliksteuermodul platzsparend durch das Getriebesteuermodul abgedeckt im Getriebe verbaut. Damit kann auch die Positionierung des Getriebesteuermoduls im Getriebe vereinfacht werden, da das Getriebesteuermodul direkt mit dem Getriebegehäuse und nicht indirekt über das Hydrauliksteuermodul mit dem Getriebegehäuse verbunden ist.
Im Folgenden werden Ausführungsbeispiele der Erfindung mit Bezug auf die beiliegenden Figuren detailliert beschrieben.

### KURZE BESCHREIBUNG DER FIGUREN

**Fig. 1** zeigt einen Ausschnitt aus einem Getriebe gemäß einer Ausführungsform der Erfindung.
**Fig. 2** zeigt einen Ausschnitt aus einem Getriebe gemäß einer weiteren Ausführungsform der Erfindung.
**Fig. 3** zeigt einen Ausschnitt aus einem Getriebe gemäß einer weiteren Ausführungsform der Erfindung.

Grundsätzlich sind identische oder ähnliche Teile mit den gleichen Bezugszeichen versehen.

### DETAILIERTE BESCHREIBUNG VON AUSFÜHRUNGSBEISPIELEN

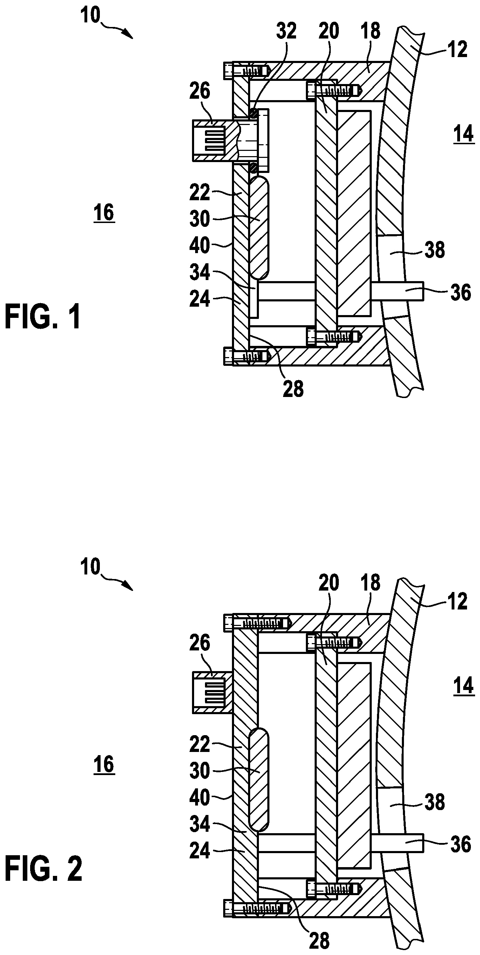

Die Fig. 1 zeigt einen Ausschnitt aus einem Getriebe 10, das von einem Getriebegehäuse 12 umschlossen ist. Das Getriebegehäuse 12 trennt einen Innenraum 14 des Getriebes 12 von einem Motorraum 16.

Das Getriebegehäuse 12 umfasst einen zweistufigen Flansch 18 in dessen Inneren ein Hydrauliksteuermodul 20 angebracht ist. Das Hydrauliksteuermodul 20 sitzt auf einem inneren Absatz des Flanschs 18 auf und ist dort mit dem Flansch 18 verschraubt. Mit dem im Inneren des Getriebegehäuses 12 angeordneten Hydrauliksteuermodul 20 kann das Getriebe 10 hydraulisch betätigt werden. Statt einer hydraulischen Betätigung kann auch ein elektromechanische Betätigungssystem für das Getriebe verwendet werden.

Auf einem äußeren Absatz des Flanschs 18 sitzt ein Getriebesteuermodul 22 auf dem Flansch 18 auf und ist dort mit dem Flansch 18 verschraubt.

Das Getriebesteuermodul 22 umfasst eine Trägerplatte 24, in die ein Getriebestecker 26 integriert ist und an deren Innenseite 28 ein Elektronikbaustein (TCU) 30 angebracht ist. im Inneren des Getriebegehäuses angeordnet.

Der Getriebestecker 26 ist durch eine Aussparung bzw. Öffnung in der Trägerplatte 24 geführt und mittels eines Dichtrings 32 derart an die Trägerplatte 24 montiert, dass die Öffnung öldicht verschlossen ist. Mit dem Getriebestecker 26 kann das Getriebesteuermodul 22 mit einem Kabelbaum des Fahrzeugs, in dem das Getriebe 10 verbaut ist, elektrisch verbunden werden.

Der Elektronikbaustein 30 und eine elektrische Verbindungstechnik 34 mit elektrischen Leitungen 34 sind an der Innenseite 28 des Getriebesteuermoduls 22 angebracht. Dort können auch ein Sensor 36 und ein Zwischenstecker angebracht sein. Der Sensor 36 ragt durch eine Öffnung 38 im Getriebegehäuse 12, durch die auch elektrische Leitungen in das Innere des Getriebes 10 führen können und die von dem Flansch 18 umgeben wird.

Auf der Innenseite des Getriebesteuermoduls 22 können weiter ein Zwischenstecker zum Verbinden mit einer elektrischen Leitung im Inneren des Getriebes 10 und eine Aktuatorkontaktierung zum Verbinden mit einem Aktuator des Getriebes 10 am Getriebesteuermodul 22 angebracht sein.
Bauteile, wie etwa die Bauteile 20, 30, 34, 36, im Getriebeinnenraum 14 liegen ganz oder teilweise direkt im Getriebeöl (ATF) und können den Temperaturen (-40 ... +150°C), die im Getriebe 10 auftreten, ausgesetzt sein. Bauteile außerhalb des Getriebes 10 im Motorraum 16 können Temperaturen bis ca. 120°C ausgesetzt sein. Daher dient eine Außenfläche 40 der Trägerplatte 24 als Kühlfläche für das Getriebesteuermodul 22. Zur besseren Wärmeleitung ist der Elektronikbaustein thermisch leitend mit der Trägerplatte 24 verbunden und kann von dieser gekühlt werden.
Die Fig. 2 zeigt ein Getriebesteuermodul 22, bei dem die elektrischen Verbindungen 34 in die Trägerplatte 24 integriert sind. Der Getriebestecker 26 und der Elektronikbaustein 30 sind in die Trägerplatte 24 eingegossen.

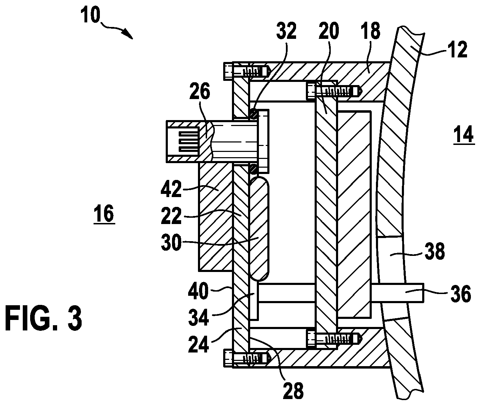

Die Fig. 3 zeigt ein Getriebesteuermodul 22 an dessen Außenseite 40 ein Motorsteuerbaustein 42 angebracht ist, der Ansteuerungskomponenten für einen elektrischen Motor des Getriebes 10 umfasst. Für die Ansteuerung des Motors wird ein Eingangsfilter und bei einem EC-Motor noch eine B6-Brücke benötigt. Der Eingangsfilter besteht aus Kondensatoren, Spulen und Feldeffekttransistoren.
Ergänzend ist darauf hinzuweisen, dass "umfassend" keine anderen Elemente oder Schritte ausschließt und "eine" oder "ein" keine Vielzahl ausschließt. Bezugszeichen in den Ansprüchen sind nicht als Einschränkung anzusehen.

## Patentansprüche

1. Getriebe (10) für ein Fahrzeug, das Getriebe (10) umfassend:
ein Gehäuse (12) mit einer Öffnung (38);
ein Getriebesteuermodul (22), das die Öffnung (38) dichtend verschließt; ein Hydrauliksteuermodul (20);
wobei das Getriebesteuermodul (22) einen Elektronikbaustein (30) mit einer elektronischen Schaltung zur Steuerung des Getriebes umfasst;
wobei das Getriebesteuermodul (22) elektrische Verbindungen (34), die mit dem Elektronikbausteins (30) verbunden sind, umfasst;
wobei das Getriebesteuermodul (22) einen Modulträger (24), auf dem der Elektronikbaustein (30) und die elektrischen Verbindungen (34) angebracht sind, umfasst;
wobei der Modulträger (24) eine Modulträgerplatte mit einer Innenfläche (28) und einer Außenfläche (40) umfasst,
wobei der Modulträger (24) als Abdeckung zum dichtenden Verschließen eines Getriebeinnenraums (14) ausgeführt ist, wobei der Elektronikbaustein (30) auf der Innenfläche (28) der Modulträgerplatte angeordnet ist und der Elektronikbaustein (30) thermisch mit der Modulträgerplatte verbunden ist, wobei die Innenfläche (28) der Modulträgerplatte dem Getriebeinnenraum (14) zugewandt ist und die Außenfläche (40) als Kühlfläche für das Getriebesteuermodul (22) ausgeführt ist;
wobei die Öffnung (38) von einem Flansch (18) begrenzt ist, mit dem das Getriebesteuermodul (22) verbunden ist; **dadurch gekennzeichnet, dass** der Flansch (18) zweistufig ist und das Hydrauliksteuermodul (20) zwischen dem Getriebesteuermodul (22) und der Öffnung (38) an dem Flansch (18) auf einem inneren Absatz des Flansches (18) verschraubt ist.

2. Getriebe (10) nach Anspruch 1, wobei das Getriebesteuermodul (22) einen Getriebestecker (26) zum Anschließen eines Kabelbaums an das Getriebesteuermodul (10) umfasst;
wobei der Getriebestecker (26) in den Modulträger (24) integriert ist.

3. Getriebe (10) nach Anspruch 2,
wobei der Getriebestecker (26) als separates Teil dichtend in eine Aussparung in den Modulträger (24) montiert ist.

4. Getriebe (10) nach Anspruch 2,
wobei der Getriebestecker (26) in den Modulträger eingespritzt ist.

5. Getriebe (10) nach einem der vorhergehenden Ansprüche,
wobei der Modulträger (24) als Leiterplatte oder als umspritztes Stanzgitter ausgeführt ist.

6. Getriebe (10) nach einem der vorhergehenden Ansprüche,
wobei das Getriebesteuermodul (22) einen Motorsteuerbaustein (42) für einen elektrischen Motor des Getriebes (10) umfasst;
wobei der Motorsteuerbaustein (42) an einer Außenseite (40) des Modulträgers (24) angebracht ist.

## Claims

1. Gearbox (10) for a vehicle, the gearbox (10) comprising:
a housing (12) with an opening (38);
a gearbox control module (22), which gearbox control module sealingly closes off the opening (38);
a hydraulics control module (20);
wherein the gearbox control module (22) comprises an electronics component (30) with an electronic circuit for controlling the gearbox;
wherein the gearbox control module (22) comprises electrical connections (34) that are connected to the electronics component (30);
wherein the gearbox control module (22) comprises a module carrier (24) on which the electronics component (30) and the electrical connections (34) are mounted;
wherein the module carrier (24) comprises a module carrier plate having an inner surface (28) and an outer surface (40),
wherein the module carrier (24) is designed as a cover for sealingly closing off a gearbox interior (14),
wherein the electronics component (30) is arranged on the inner surface (28) of the module carrier plate, and the electronics component (30) is thermally connected to the module carrier plate,
wherein the inner surface (28) of the module carrier plate faces towards the gearbox interior (14), and the outer surface (40) is configured as a cooling surface for the gearbox control module (22) ;
wherein the opening (38) is delimited by a flange (18) to which the gearbox control module (22) is connected;
**characterized in that**
the flange (18) is two-stepped, and the hydraulics control module (20) between the gearbox control module (22) and the opening (38) is screwed onto the flange (18) on an internal shoulder of the flange (18).

2. Gearbox (10) according to Claim 1, wherein the gearbox control module (22) comprises a gearbox plug connector (26) for the connection of a wiring loom to the gearbox control module (10);
wherein the gearbox plug connector (26) is integrated into the module carrier (24).

3. Gearbox (10) according to Claim 2,
wherein the gearbox plug connector (26), as a separate part, is installed sealingly into a cutout in the module carrier (24).

4. Gearbox (10) according to Claim 2,
wherein the gearbox plug connector (26) is injection-molded into the module carrier.

5. Gearbox (10) according to one of the preceding claims, wherein the module carrier (24) is in the form of a printed circuit board or an insert-molded lead frame.

6. Gearbox (10) according to one of the preceding claims, wherein the gearbox control module (22) comprises a motor control component (42) for an electric motor of the gearbox (10);
wherein the motor control component (42) is mounted on an outer side (40) of the module carrier (24).

## Revendications

1. Boîte de vitesses (10) pour un véhicule, la boîte de vitesses (10) comprenant :
un boîtier (12) avec une ouverture (38) ;
un module de commande de boîte de vitesses (22) qui ferme hermétiquement l'ouverture (38) ;
un module de commande hydraulique (20) ;
le module de commande de boîte de vitesses (22) comprenant un composant électronique (30) avec un circuit électronique pour la commande de la boîte de vitesses ;
le module de commande de boîte de vitesses (22) comprenant des connexions électriques (34) qui sont connectées au composant électronique (30) ;
le module de commande de boîte de vitesses (22) comprenant un support de module (24) sur lequel sont montés le composant électronique (30) et les connexions électriques (34) ;
le support de module (24) comprenant une plaque de support de module avec une surface intérieure (28) et une surface extérieure (40),
le support de module (24) étant réalisé sous forme de recouvrement pour la fermeture hermétique d'un espace intérieur de boîte de vitesses (14),
le composant électronique (30) étant disposé sur la surface intérieure (28) de la plaque de support de module et le composant électronique (30) étant connecté thermiquement à la plaque de support de module, la surface intérieure (28) de la plaque de support de module étant tournée vers l'espace intérieur de boîte de vitesses (14) et la surface extérieure (40) étant réalisée sous forme de surface de refroidissement pour le module de commande de boîte de vitesses (22) ;
l'ouverture (38) étant limitée par une bride (18) à laquelle est connecté le module de commande de boîte de vitesses (22) ;
**caractérisée en ce que**
la bride (18) a deux étages et le module de commande hydraulique (20) est vissé entre le module de commande de boîte de vitesses (22) et l'ouverture (38) au niveau de la bride (18) sur un épaulement intérieur de la bride (18).

2. Boîte de vitesses (10) selon la revendication 1, dans laquelle le module de commande de boîte de vitesses (22) comprend un connecteur enfichable de boîte de vitesses (26) pour le raccordement d'un faisceau de câbles au module de commande de boîte de vitesses (10) ;
le connecteur enfichable de boîte de vitesses (26) étant intégré dans le support de module (24).

3. Boîte de vitesses (10) selon la revendication 2, dans laquelle le connecteur enfichable de boîte de vitesses (26) est monté sous forme de pièce séparée de manière hermétique dans un évidement dans le support de module (24).

4. Boîte de vitesses (10) selon la revendication 2, dans laquelle le connecteur enfichable de boîte de vitesses (26) est moulé par injection dans le support de module.

5. Boîte de vitesses (10) selon l'une quelconque des revendications précédentes, dans laquelle le support de module (24) est réalisé sous forme de carte à circuits intégrés ou sous forme de grille estampée surmoulée.

6. Boîte de vitesses (10) selon l'une quelconque des revendications précédentes, dans laquelle le module de commande de boîte de vitesses (22) comprend un composant de commande de moteurs (42) pour un moteur électrique de la boîte de vitesses (10) ; le composant de commande de moteur (42) étant monté sur un côté extérieur (40) du support de module (24).
